# EUROPEAN PATENT SPECIFICATION

(11) **EP 2 882 888 B1**
(45) Date of publication and mention of the grant of the patent: **03.10.2018**
(21) Application number: 13753419.4
(22) Date of filing: 23.07.2013
(51) Int. Cl.: C25B 9/04, C23C 14/16, C23C 14/02

(54) **CONTACT STRIPS FOR ELECTROLYSIS CELLS**
KONTAKTSTREIFEN FÜR ELEKTROLYSEZELLEN
BANDES DE CONTACT POUR CELLULES D'ÉLECTROLYSE

(30) Priority: 10.08.2012 DE 102012015802
(43) Date of publication of application: 17.06.2015
(73) Proprietor: Thyssenkrupp Uhde Chlorine Engineers (Italia) S.r.l., 20134 Milan (IT)
(72) Inventor: HOORMANN, Dirk, 59368 Werene an der Lippe (DE); DONST, Dmitri, 50827 Köln (DE); FUNCK, Frank, 46119 Oberhausen (DE); WOLTERING, Peter, 48485 Neuenkirchen (DE); TOROS, Peter, 45326 Essen (DE); HOFMANN, Philipp, 44137 Dortmund (DE); POLCYN, Gregor, 44227 Dortmund (DE)
(74) Representative: Fabry, Bernd
(86) International application number: PCT/EP2013/065522
(87) International publication number: WO 2014/023572

(56) References cited:
- WO-A2-2004/007805
- US-A1- 2002 081 478
- US-A1- 2004 081 881
- US-A1- 2005 260 484
- US-A1- 2009 127 226
- US-A1- 2009 293 447
- US-A1- 2010 092 692
- "NiV7 for Semiconductor Applications", Umicore Thin Film Products Brochures / Technical Data Downloads, 15 October 2008 (2008-10-15), pages 1-4, XP055099814, online Retrieved from the Internet: URL:http://www.thinfilmproducts.umicore.co m/Products/TechnicalData/show_datenblatt_n iv7.pdf [retrieved on 2014-02-03]

## Description

### FIELD OF THE INVENTION

The invention relates to contact strips, particularly for electrolysis cells (membrane cells), a process for their manufacture and the use of specific metal compositions to obtain conductive compounds.

### PRIOR ART

Electrolysis cells that are connected via contact strips are already known from, for example, WO 1998 15675 A1 (Uhde). Contact strips serve not least to establish electric contact between adjacent cells; however, there are various alternatives on the one hand to manufacture these contact strips and on the other hand to attach them to the cell walls.

A manufacturing process for the production of contact strips of this kind is also described in WO 2001 085388 A1 (Uhde). Here, laser pressure-welding is used to weld contact strips of material of good electric conductivity onto a titanium sheet strip.

DE 2010 023410 A1 (Uhde) describes the manufacture of platinum electrodes for the persulfate electrolysis. In this process a layer of platinum of a thickness of 0.5 to 10 µm is deposited on a substrate metal. Embodiment example 1 describes the manufacture of an electrode in which nickel is applied onto a substrate metal by using the PVD process. However, the person skilled in the art is immediately aware that this must be a mistake as the complete document is exclusively about coating with platinum.

In case sheet strips of dissimilar materials are connected to each other, a known practice is to do so by explosion-bonding. Here, an explosive layer is ignited at high velocity to explosion-bond the coating material to the substrate material so that grid-type metal bonding is achieved between the two materials. However, this method is comparatively sophisticated, especially cost-intensive. In addition, this method produces 20 to 50 % material scrap, as the precision of explosion-bonding is too low.

The objective of the invention is to provide contact strips which are as reasonably priced as possible but are nonetheless highly conductive and to develop a highly effective process which allows manufacturing such contact strips of high electric effectiveness on a large scale.

### DESCRIPTION OF THE INVENTION

In a first embodiment, the invention relates to contact strips for electrolysis cells, which consist of a titanium strip coated with a layer of nickel containing 0 to 10 wt.-% vanadium by way of physical vapour deposition.

Surprisingly it has been found that a contact strip provided with such coating that had been applied by physical vapour deposition features high electric effectiveness.

In a preferred embodiment of the invention the nickel contains vanadium of approx. 1 to approx. 8 wt.-% and preferably 7 wt.-%. In this way conductivity and flexibility of the contact strips are further improved. Nickel alloys containing 7 wt.-% vanadium normally serve for semiconductor applications and are commercially available from Umicore AG under the name 'NiV7'.

Also preferred are contact strips with a layer of nickel or nickel-vanadium of a thickness of approx. 0.5 to approx. 10 µm, preferably of approx. 1 to approx. 8 µm and most preferably of approx. 1 to approx. 5 µm.

Another subject-matter of the invention relates to a process for the manufacture of contact strips for electrolysis cells, according to which a layer of nickel containing vanadium of 0 to 10 wt.-%, preferably approx. 1 to approx. 8 wt.-% and most preferably 7 wt.-% is deposited on a titanium strip by way of physical vapour deposition.

In a preferred but only exemplary embodiment of the invention, the physical vapour deposition is carried out by
(a) loading a vacuum chamber with at least one titanium strip,
(b) closing and evacuating the vacuum chamber,
(c) cleaning the substrate by introducing a gaseous reducing agent into the vacuum chamber,
(d) subsequently removing the gaseous reducing agent,
(e) introducing the nickel or nickel-vanadium into the vacuum chamber and coating the titanium strip with an approx. 0.5 to approx. 10 µm thick layer by vapour deposition, ion plating or cathode sputtering, and
(f) finally, re-flooding the vacuum chamber and removing the coated substrate from the chamber.

Additionally it has proven to be of advantage to perform the process steps (a) to (f) of the physical vapour deposition from one step to the next under vacuum at different pressures, which are set by means of an inert gas.

Most preferably used as a coating process is a vapour deposition method from the group of thermal deposition, electron beam deposition, laser beam deposition, arc deposition and molecular beam epitaxy.

Thermal deposition or *thermal evaporation* is a high-vacuum-based coating method from the group of PVD processes. In this process all starting material is heated electrically (resistively or inductively) to temperatures close to the boiling point, material vapour migrates to a substrate and condenses there in a layer. It thus constitutes one of the simplest vapour deposition methods in the field of coating technology.

In the extended sense, thermal deposition is understood to be a group of PVD processes in which the starting material is heated in various ways. This group includes, for example, vapour deposition methods using laser beams, electron beams or an arc. Molecular beam epitaxy is another method from this group.

For thermal deposition the starting material is heated to temperatures close to the boiling point. Individual atoms, atom clusters or molecules separate, which means that they evaporate and migrate through the vacuum chamber. On account of the arrangement between evaporation source and substrate, the material vapour gets to as far as the cooler substrate on the opposite side and condenses. A thin layer of the evaporated material deposits on the substrate.

As most of the other PVD processes, thermal deposition is also a high-vacuum process. Typical process pressures are 10⁻⁶ mbar. This is due to various reasons, on the one hand collisions with the gas particles still existing in the vacuum are minimised by the low pressure (in this pressure range the mean free path length is much longer than the distance of the evaporation source to the substrate), on the other hand it is required that the process pressure be below the gas pressure of the material to be evaporated.

A further subject-matter of the invention refers to the use of nickel of a vanadium content of 0 to 10 wt.-%, preferably approx. 1 to approx. 8 wt.-% and most preferably 7 wt.-% for the manufacture of a conductive layer on a titanium strip.

Finally, the last embodiment of the invention relates to the use of a titanium strip provided with a coating of nickel of a vanadium content of 0 to 10 wt.-%, preferably approx. 1 to approx. 8 wt.-% and most preferably 7 wt.-% as a contact strip for electrolysis cells.

Preferentially such titanium strips are used that have a nickel or nickel-vanadium layer of a thickness of approx. 0.5 to approx. 10 µm, preferably approx. 1 to approx. 8 µm and most preferably approx. 1 to approx. 5 µm.

### Examples

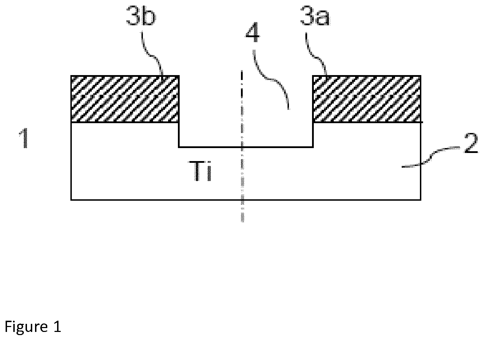

Additional features, details and advantages of the invention emerge from the following description and **Figure 1** showing a simplified sectional view of a contact strip according to the invention.

The contact strip generally designated as **1** is made up by a titanium strip **2,** coated with a layer of nickel or a layer of nickel containing 7 % vanadium by way of physical vapour deposition.

To allow that two contact webs **3a** and **3b** be formed, the centre part of especially the contact strip may have been removed mechanically, for example, such that a longitudinal groove **4** is obtained.

Below an example is described in more detail: A titanium strip coated with NiV7 in a PVD process was attached to the anode side of a cell element. A current of 16.3 kA was applied to the cell element. A voltage drop of 6 mV per kA/m² could be measured. This value corresponds to contact strips that have been coated by explosion-bonding. Hence it could be demonstrated that this process serves to manufacture contact strips of high electric effectiveness.

Advantages involved in the present invention:
- By using the PVD process it is possible to achieve high material utilisation, this process being thus less expensive than the explosion-bonding method.
- The process allows coating larger contact surfaces and thereby further reducing voltage drops, which can be compared to explosion-bonding. Thus it is possible to further increase the electric effectiveness.

List of reference numbers and designations:
- 1: Contact strips
- 2: Titanium strip
- 3a, 3b: Contact webs
- 4: Groove

## Claims

1. Contact strip for electrolysis cells, the contact strip consisting of a titanium strip which has been coated with a layer of nickel containing 0 to 10 wt.-% vanadium by way of physical vapour deposition.

2. Contact strip according to claim 1, **characterised in that** the layer of nickel contains 7 wt.-% vanadium.

3. Contact strip according to claim/s 1 and/or 2, **characterised in that** the layer of nickel or nickel-vanadium has a thickness of approx. 0.5 to approx. 10 µm.

4. Contact strip according to at least one of claims 1 to 3, **characterised in that** the layer of nickel or nickel-vanadium has a thickness of approx. 1 to approx. 8 µm.

5. Contact strip according to at least one of claims 1 to 4, **characterised in that** the layer of nickel or nickel-vanadium has a thickness of approx. 1 to approx. 5 µm.

6. Process for the manufacture of contact strips for electrolysis cells, according to which a layer of nickel containing 0 to 10 wt.-% vanadium is deposited on a titanium strip by way of physical vapour deposition.

7. Process according to claim 6, **characterised in that** a layer of nickel containing 7 wt.-% vanadium is deposited.

8. Process according to claim/s 6 and/or 7, **characterised in that** the physical vapour deposition is carried out by
(a) loading a vacuum chamber with at least one titanium strip,
(b) closing and evacuating the vacuum chamber,
(c) cleaning the substrate by introducing a gaseous reducing agent into the vacuum chamber,
(d) subsequently removing the gaseous reducing agent,
(e) introducing the nickel or nickel-vanadium into the vacuum chamber and coating the titanium strip with an approx. 0.5 to approx. 10 µm thick layer by vapour deposition, ion plating or cathode sputtering, and
(f) finally re-flooding the vacuum chamber and removing the coated substrate from the chamber.

9. Process according to claim 8, **characterised in that** the process steps (a) to (f) of physical vapour deposition are performed from one step to the next under vacuum at different pressures, which are set by means of an inert gas.

10. Process according to at least one of claims 6 to 9, **characterised in that** a vapour deposition method from the group of thermal deposition, electron beam deposition, laser beam deposition, arc deposition and molecular beam epitaxy is selected as a coating process.

11. Use of nickel of a vanadium content of 0 to 10 wt.-% for the manufacture of a conductive layer on a titanium strip by performing a PVD process.

12. Use according to claim 11, **characterised in that** nickel containing 7 wt.-% vanadium is used.

13. Use of a titanium strip coated with nickel of a vanadium content of 0 to 10 wt.-% as a contact strip for electrolysis cells.

14. Use according to claim 13, **characterised in that** nickel containing 7 wt.-% vanadium is used.

15. Use according to claim/s 13 and/or 14, **characterised in that** titanium strips with a thickness of the nickel or nickel-vanadium layer of approx. 0.5 to approx. 10 µm are employed.

## Patentansprüche

1. Kontaktstreifen für Elektrolysezelle, wobei besagter Kontaktstreifen aus einem Titanstreifen besteht, welcher durch physikalische Gasphasenabscheidung mit einer Schicht aus Nickel enthaltend 0 bis 10 Gew.-% Vanadium versehen ist.

2. Kontaktstreifen nach Anspruch 1, **dadurch gekennzeichnet, dass** die Nickelschicht 7 Gew.-% Vanadium aufweist.

3. Kontaktstreifen nach den Ansprüchen 1 und/oder 2, **dadurch gekennzeichnet, dass** die Nickel- oder Nickel-Vanadiumschicht eine Stärke von etwa 0,5 bis etwa 10 µm aufweist.

4. Kontaktstreifen nach mindestens einem der Ansprüche 1 bis 3, **dadurch gekennzeichnet, dass** die Nickel- oder Nickel-Vanadiumschicht eine Stärke von etwa 1 bis etwa 8 µm aufweist.

5. Kontaktstreifen nach mindestens einem der Ansprüche 1 bis 4, **dadurch gekennzeichnet, dass** die Nickel- oder Nickel-Vanadiumschicht eine Stärke von etwa 1 bis etwa 5 µm aufweist.

6. Verfahren zur Herstellung von Ko
ntaktstreifen für Elektrolysezellen, gemäß dem eine Nickelschicht enthaltend 0 bis 10 Gew.-% Vanadium auf einen Titanstreifen auf dem Wege der physikalischen Gasphasenabscheidung aufgebracht wird.

7. Verfahren nach Anspruch 6, **dadurch gekennzeichnet, dass** eine Schicht von Nickel enthaltend 7 Gew.-% Vanadium aufgebracht wird.

8. Verfahren nach den Ansprüchen 6 und/oder 7, **dadurch gekennzeichnet, dass** die physikalische Gasphasenabscheidung wie folgt durchgeführt wird:
(a) Beladen der Vakuumkammer mit wenigstens einem Titanstreifen;
(b) Schließen und Evakuieren der Vakuumkammer;
(c) Reinigen des Substrates durch Einleitung eines gasförmigen Reduktionsmittels in die Vakuumkammer;
(d) nachfolgendes Entfernen des Reduktionsmittels;
(e) Einbringen von Nickel oder Nickel-Vanadium in die Vakuumkammer und Beschichten des Titanstreifens mit einer etwa 0,5 bis etwa 10 µm dicken Schicht durch Gasphasenabscheidung, lonenbeschichtung oder Kathodensputtering, und
(f) schließlich Wiederherstellung des Normaldrucks in der Vakuumkammer und Entnahme des beschichteten Substrats aus der Kammer.

9. Verfahren nach Anspruch 8, **dadurch gekennzeichnet, dass** die Verfahrensschritte (a) bis (f) bezüglich der physikalischen Gasphasenbeschichtung nacheinander bei unterschiedlichen Drücken unter Einsatz von Inertgas durchgeführt werden.

10. Verfahren nach mindestens einem der Ansprüche 6 bis 9, **dadurch gekennzeichnet, dass** das Verfahren der Gasphasenbeschichtung ausgewählt ist aus der Gruppe umfassend thermisches Beschichten, Elektronenstrahlbeschichtung, Laserstrahlbeschichtung, Lichtbogenbeschichtung und Molekularstrahlepitaxie.

11. Verwendung von Nickel mit einem Vanadiumgehalt von 0 bis 10 Gew.-% für die Herstellung einer leitfähigen Schicht auf einem Titanstreifen mit Hilfe eines PVD Prozesses.

12. Verwendung nach Anspruch 11, **dadurch gekennzeichnet, dass** man Nickel enthaltend 7 Gew.-% Vanadium einsetzt.

13. Verwendung eines Titanstreifens beschichtet mit Nickel, welches einen Vanadiumgehalt von 0 bis 10 Gew.-% aufweist, als Kontaktstreifen für eine Elektrolysezelle.

14. Verwendung nach Anspruch 13, **dadurch gekennzeichnet, dass** man Nickel enthaltend 7 Gew.-% Vanadium einsetzt.

15. Verwendung nach den Ansprüchen 13 und/oder 14, **dadurch gekennzeichnet, dass** Titanstreifen mit einer Stärke der Nickel- oder Nickel-Vanadiumschicht von etwa 0,5 bis etwa 10 µm zum Einsatz kommen

## Revendications

1. Bande de contact pour des cellules d'électrolyse, la bande de contact étant constituée d'une bande de titane qui a été revêtue d'une couche de nickel contenant 0 à 10 % en poids de vanadium au moyen d'un dépôt physique en phase vapeur.

2. Bande de contact selon la revendication 1, **caractérisée en ce que** la couche de nickel contient 7 % en poids de vanadium.

3. Bande de contact selon les revendications 1 et/ou 2, **caractérisée en ce que** la couche de nickel ou de nickel-vanadium a une épaisseur d'environ 0,5 à environ 10 µm.

4. Bande de contact selon au moins l'une des revendications 1 à 3, **caractérisée en ce que** la couche de nickel ou de nickel-vanadium a une épaisseur d'environ 1 à environ 8 µm.

5. Bande de contact selon au moins l'une des revendications 1 à 4, **caractérisée en ce que** la couche de nickel ou de nickel-vanadium a une épaisseur d'environ 1 à environ 5 µm.

6. Procédé pour la fabrication de bandes de contact pour des cellules d'électrolyse, selon lequel une couche de nickel contenant 0 à 10 % en poids de vanadium est déposée sur une bande de titane au moyen d'un dépôt physique en phase vapeur.

7. Procédé selon la revendication 6, **caractérisé en ce qu'**une couche de nickel contenant 7 % en poids de vanadium est déposée.

8. Procédé selon les revendications 6 et/ou 7, **caractérisé en ce que** le dépôt physique en phase vapeur est effectué par
(a) chargement d'au moins une bande de titane dans une chambre à vide,
(b) fermeture et mise sous vide de la chambre à vide,
(c) nettoyage du substrat par introduction d'un agent réducteur gazeux dans la chambre à vide,
(d) par la suite évacuation de l'agent réducteur gazeux,
(e) introduction du nickel ou nickel-vanadium dans la chambre à vide et revêtement de la bande de titane d'une couche d'environ 0,5 à environ 10 µm d'épaisseur par dépôt en phase vapeur, placage ionique ou pulvérisation cathodique et
(f) enfin remise sous pression normale de la chambre à vide et retrait du substrat revêtu de la chambre.

9. Procédé selon la revendication 8, **caractérisé en ce que** les étapes de procédé (a) à (f) du dépôt physique en phase vapeur sont mises en oeuvre d'une étape à la suivante sous vid

10. Procédé selon au moins l'une des revendications 6 à 9, **caractérisé en ce qu'**une méthode de dépôt en phase vapeur choisie dans le groupe du dépôt thermique, du dépôt par faisceau d'électrons, du dépôt par faisceau laser, du dépôt par arc et de l'épitaxie par jets moléculaires est choisie en tant que procédé de revêtement.

11. Utilisation de nickel ayant une teneur en vanadium de 0 à 10 % en poids pour la fabrication d'une couche conductrice sur une bande de titane par la mise en oeuvre d'un procédé de PVD.

12. Utilisation selon la revendication 11, **caractérisée en ce que** du nickel contenant 7 % en poids de vanadium est utilisé.

13. Utilisation d'une bande de titane revêtue de nickel ayant une teneur en vanadium de 0 à 10 % en poids en tant que bande de contact pour des cellules d'électrolyse.

14. Utilisation selon la revendication 13, **caractérisée en ce que** du nickel contenant 7 % en poids de vanadium est utilisé.

15. Utilisation selon les revendications 13 et/ou 14, **caractérisée en ce que** des bandes de titane ayant une épaisseur de la couche de nickel ou de nickel-vanadium d'environ 0,5 à environ 10 µm sont employées.
